(19) Europäisches Patentamt
European Patent Office
Office européen des brevets

(11) EP 2 857 471 B1

(12) EUROPEAN PATENT SPECIFICATION

(45) Date of publication and mention of the grant of the patent:
**13.09.2017 Bulletin 2017/37**

(21) Application number: **13797401.0**

(22) Date of filing: **31.05.2013**

(51) Int Cl.:
***H01L 51/52*** $^{(2006.01)}$ ***C09J 133/04*** $^{(2006.01)}$
***C09J 163/00*** $^{(2006.01)}$

(86) International application number:
**PCT/KR2013/004848**

(87) International publication number:
**WO 2013/180536 (05.12.2013 Gazette 2013/49)**

(54) **PRODUCTION METHOD FOR AN ORGANIC ELECTRONIC DEVICE**

HERSTELLUNGSVERFAHREN FÜR EINE ORGANISCHE ELEKTRONISCHE VORRICHTUNG

PROCÉDÉ DE PRODUCTION D'UN DISPOSITIF ÉLECTRONIQUE ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2012 KR 20120058826**

(43) Date of publication of application:
**08.04.2015 Bulletin 2015/15**

(73) Proprietor: **LG Chem, Ltd.**
**Seoul 150-721 (KR)**

(72) Inventors:
- **CHO, Yoon Gyung**
  **Daejeon 305-380 (KR)**
- **CHANG, Suk Ky**
  **Daejeon 305-380 (KR)**
- **SHIM, Jung Sup**
  **Daejeon 305-380 (KR)**
- **YOO, Hyun Jee**
  **Daejeon 305-380 (KR)**
- **LEE, Seung Min**
  **Daejeon 305-380 (KR)**

(74) Representative: **Cabinet Plasseraud**
**66, rue de la Chaussée d'Antin**
**75440 Paris Cedex 09 (FR)**

(56) References cited:
**EP-A2- 1 804 310**
**WO-A1-2007/111607**
**WO-A1-2009/126115**
**JP-A- 2008 059 945**
**JP-A- 2008 059 945**
**JP-B2- 4 657 923**
**KR-A- 20110 134 959**
**KR-A- 20120 046 704**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

BACKGROUND

### 1. Field of the Invention

The present invention relates to a method of manufacturing an organic electronic device using a pressure-sensitive adhesive film.

### 2. Discussion of Related Art

An organic electronic element is an element capable of inducing flow of charges between an electrode and an organic material using holes and/or electrons. The organic electronic element is classified into an electronic element in which an exciton formed in an organic material layer is separated into an electron and a hole by a photon flowing into a element from an external light source and the separated electron and hole are transferred to different electrodes, respectively, thereby serving as a current source; or an electronic element operated by an electron and a hole, which are injected into an organic material by applying a voltage or current to at least two electrodes. Such an organic electronic element may be, for example, an organic light emitting diode (OLED). The organic light emitting diode refers to a self-emissive diode using an electroluminescent phenomenon emitting light when a current flows in an emissive organic compound. Since the organic light emitting diode has excellent thermal stability and a low drive voltage, it receives attention as a next generation material in various fields of industries such as displays, lightings, etc. However, the organic light emitting diode is vulnerable to moisture, and thus research to compensate this disadvantage is needed.

JP 2008 095545 A discloses a method of manufacturing organic electronic devices comprising the steps of attaching a pressure-sensitive adhesive film to a top surface of a substrate, irradiating the adhesive film and heating it.

SUMMARY OF THE INVENTION

The present invention is directed to providing a method of manufacturing an organic electronic device using a pressure-sensitive adhesive film.

One aspect of the present invention provides a method of manufacturing an organic electronic device, which includes: attaching a pressure-sensitive adhesive film to a top surface of a substrate on which an organic electronic element is formed to encapsulate an entire surface of the organic electronic element; irradiating the pressure-sensitive adhesive film encapsulating the entire surface of the organic electronic element with light at an intensity of 0.1 to 100 $mW/cm^2$ for 10 seconds to 10 minutes so as to have a curing rate of 10%-90%; and then applying heat to the pressure-sensitive adhesive film at 70 to 90°C for 30 minutes to 1 hour and 30 minutes. Here, the pressure-sensitive adhesive film includes a curable resin and a photoinitiator.

In one embodiment, the pressure-sensitive adhesive film may be used as an encapsulation layer for encapsulating the entire surface of the organic electronic element.

In the method of manufacturing an organic electronic device, the "entire surface of the organic electronic element is encapsulated" refers that the pressure-sensitive adhesive film is attached to the substrate on which the organic electronic element is formed to cover the entire surface of the organic electronic element with the pressure-sensitive adhesive film. The pressure-sensitive adhesive film is used to encapsulate an entire area of the organic electronic element, and does not necessarily encapsulate an entire surface of the substrate. Accordingly, an area of the pressure-sensitive adhesive film may be controlled according to the desired kind and structure of the organic electronic device.

In the specification, the "organic electronic device" refers to a device including an organic electronic element, a substrate on which the organic electronic element is formed, or a component for protecting the organic electronic element, and the "organic electronic element" refers to an element capable of substantially inducing the flow of charges between an electrode and an organic material using a hole and/or an electron.

In one embodiment, the operation of attaching a pressure-sensitive adhesive film to a top surface of a substrate on which the organic electronic element is formed to encapsulate an entire surface of the organic electronic element (hereinafter, the operation of attaching a pressure-sensitive adhesive film) may be performed using a separately-manufactured pressure-sensitive adhesive film. The pressure-sensitive adhesive film may be designed to exhibit pressure-sensitive adhesive performance by curing the above-described pressure-sensitive adhesive composition. In addition, in another embodiment, the operation of attaching a pressure-sensitive adhesive film may be performed by attaching the pressure-sensitive adhesive film formed by coating and curing the pressure-sensitive adhesive composition on an encapsulation substrate to the substrate on a side of which the organic electronic element is formed. However, such a method is not limited thereto, and for example, the pressure-sensitive adhesive film may be attached to the substrate by forming the pressure-sensitive adhesive film by directly coating the pressure-sensitive adhesive composition on the

substrate on which the organic electronic element is formed.

When the operation of attaching a pressure-sensitive adhesive film progresses using the separately-manufactured pressure-sensitive adhesive film, an order of attaching the substrate and the encapsulation substrate to both surfaces of the pressure-sensitive adhesive is not limited. That is, as one embodiment, referring to FIG. 1, the encapsulation substrate 20 is first attached to any one surface of the pressure-sensitive adhesive film 40, and the other surface of the pressure-sensitive adhesive film 40 may be attached to the substrate 10 on which the organic electronic element 30 is formed. In addition, in another embodiment, after one surface of the pressure-sensitive adhesive film is previously attached to the substrate on which the organic electronic element is formed, the other surface of the pressure-sensitive adhesive film may be attached to the encapsulation substrate. In addition, in still another embodiment, the substrate and the encapsulation substrate may be simultaneously attached to both surfaces of the pressure-sensitive adhesive film.

In one embodiment, the operation of attaching a pressure-sensitive adhesive film may be performed by applying a predetermined pressure. The attachment of the substrate and/or encapsulation substrate using a pressure-sensitive adhesive property of the pressure-sensitive adhesive film may be alternatively described with the term "lamination" used herein.

In one embodiment, the operation of laminating the substrate and/or encapsulation substrate to the pressure-sensitive adhesive film may be performed using roll lamination. Accordingly, as described above, when the substrate and the encapsulation substrate are sequentially attached to the pressure-sensitive adhesive film, the roll lamination may be performed while the releasing film is attached to one surface of the pressure-sensitive adhesive film. In the conventional art, when an adhesive film is used, in an operation of attaching a substrate and an encapsulation substrate by means of the adhesive, an organic electronic device is damaged or bent due to heat applied thereto. However, as described above, when the substrate and the encapsulation substrate are attached using the pressure-sensitive adhesive film by the roll lamination, there is no risk of the above-described problems.

In one embodiment, the operation of irradiating the pressure-sensitive adhesive film encapsulating the entire surface of the organic electronic element with light (hereinafter, the light radiating operation) may be, for example, a process of forming an encapsulation layer encapsulating the organic electronic element by curing the pressure-sensitive adhesive film with light. Accordingly, in this operation, the pressure-sensitive adhesive film does not have the pressure-sensitive adhesive performance any longer, and may have the same property as an adhesive.

The light radiated to the pressure-sensitive adhesive film may have a weak intensity of, for example, 0.1 to 100 mW/cm$^2$, 0.1 to 90 mW/cm$^2$, 0.1 to 80 mW/cm$^2$, 0.1 to 70 mW/cm$^2$, 0.1 to 60 mW/cm$^2$, 0.1 to 50 mW/cm$^2$, 0.1 to 40 W/cm$^2$, 0.1 to 30 mW/cm$^2$, 0.1 to 20 mW/cm$^2$, 0.1 to 10 mW/cm$^2$, 0.1 to 8 mW/cm$^2$, 1 to 8 mW/cm$^2$, or 2 to 7 mW/cm$^2$. In addition, a wavelength of the light radiated to the pressure-sensitive adhesive film may be, for example, 300 to 450 nm, 320 to 390 nm, or 395 to 445 nm. However, the wavelength range of the light is a range of a main wavelength of the radiated light, and when the light having a wavelength in the above range is radiated, a small amount of light having a wavelength beyond the above range may be included.

In one embodiment, when the light having a wavelength in the above range is radiated to the pressure-sensitive adhesive film at a suitable intensity within the above range at a room temperature for 10 seconds to 10 minutes, 30 seconds to 8 minutes, 1 to 7 minutes, 1 minute and 30 seconds to 6 minutes, or 1 minute and 30 seconds to 5 minutes, a curing rate may be 10 to 90%, 10 to 80%, 10 to 70%, 10 to 60%, 10 to 50%, 20 to 90%, 30 to 90%, 20 to 80%, 30 to 70%, 30 to 60%, or 30 to 50%. Accordingly, the pressure-sensitive adhesive film may be applied, for example, to a device which is at risk of being damaged by light.

Usually, a process of encapsulating the organic electronic device strains the organic electronic device in many times. For example, when the encapsulation film for encapsulating the organic electronic device is heat-curable, the organic electronic device may be bent or an organic electronic element present in the organic electronic device may be damaged by heat applied to the organic electronic device. In addition, though the encapsulation film for encapsulating the organic electronic device is photocurable, it is difficult to form the encapsulation layer on the organic electronic element since the organic electronic element is more likely to be damaged by light.

However, according to the method of manufacturing an organic electronic device described above, the encapsulation layer for encapsulating an entire surface of the organic electronic element may be formed without bending of or damage to the organic electronic device. In one embodiment, referring to FIG. 1, the light radiating operation may be performed by irradiating the entire surface of the organic electronic device with light in a state in which the substrate 10, the organic electronic element 30, and the encapsulation substrate 20 are laminated. Here, when the intensity of the light is controlled within the above range, the encapsulation layer 50 may be formed on the entire surface of the organic electronic element 30 without strain of the organic electronic element 30. In addition, since heat is not applied, it may prevent the bending of the organic electronic device. Accordingly, in one embodiment, even when the above-described plastic substrate having flexibility is used as a substrate for the organic electronic device, the phenomenon of bending the organic electronic device may be minimized. For example, the wavelength and radiation time of the light may be controlled the same as the above-described curing conditions of the pressure-sensitive adhesive composition.

In addition, in one embodiment, the light radiating operation may be performed at a room temperature. Accordingly, the organic electronic device may not be bent at all. The room temperature is not particularly limited, and for example, may be in the above-described range.

After the light radiating operation, an operation of applying heat to the pressure-sensitive adhesive film at 70 to 90°C, 75 to 85°C, or 78 to 83 °C for 30 minutes to 1 hour and 30 minutes, 45 minutes to 1 hour and 15 minutes, or 50 minutes to 1 hour and 10 minutes may be further included. Usually, when heat is applied to the encapsulation film for forming the encapsulation layer, the organic electronic device may be bent due to a difference in thermal expansion coefficient between the substrate and encapsulation substrate of the organic electronic device, and the pressure-sensitive adhesive film or a difference in temperature by parts in the organic electronic device. However, according to the manufacturing method in one embodiment, curing is performed by irradiating the pressure-sensitive adhesive film with light and then heating is applied to the film. Therefore, since the substrate and the encapsulating substrate between which the organic electronic element is included are previously fixed, the organic electronic device is not bent even if heat is additionally applied. In addition, when the encapsulation layer is formed by general heat curing, the organic electronic device is probably bent, and thus it is highly possible that the curing may not be sufficiently performed. In this case, moisture may penetrate into an uncured part of the encapsulation layer, and an adhesive strength may be degraded. However, since heat is applied after the light radiation in the manufacturing method according to one embodiment, an uncured part may be minimized.

In one embodiment, when such an operation of applying heat is included, the pressure-sensitive adhesive film may include a resin used in both photocuring and heat curing and a heat-curable agent. In addition, in one embodiment, a photoinitiator capable of being present in the encapsulation layer may be decomposed and removed in the operation of applying heat. Accordingly, the photoinitiator may not be present in the encapsulation layer included in the organic electronic device.

In one embodiment, the pressure-sensitive adhesive film may include a pressure-sensitive adhesive layer including the pressure-sensitive adhesive composition in a cured state. The pressure-sensitive adhesive layer may be, for example, in a solid or semi-solid state, and exhibit pressure-sensitive adhesive performance.

Hereinafter, the pressure-sensitive adhesive composition will be described in detail.

The term "pressure-sensitive adhesive composition" used herein refers to a composition capable of providing a pressure-sensitive adhesive through aging or curing or providing a pressure-sensitive adhesive by including a binder resin. In addition, the "pressure-sensitive adhesive" refers to a polymer material present in a semi-solid or solid state at a room temperature, exhibiting pressure-sensitive adhesive performance, and serving as an adhesive by post-curing. Accordingly, the pressure-sensitive adhesive composition may be cured to exhibit the pressure-sensitive adhesive performance or to exhibit adhesive performance, and thus a curing degree may be suitably controlled according to a desired physical property. Meanwhile, the pressure-sensitive adhesive used herein may be used as substantially the same meaning as the pressure-sensitive adhesive layer or pressure-sensitive adhesive film.

In the specification, the room temperature refers to a general atmospheric temperature in a room, and for example, may be a temperature of 15 to 30°C, 20 to 30°C, 15 to 28 °C, or approximately 25 °C.

In one embodiment, the pressure-sensitive adhesive composition may be a material capable of serving as an adhesive by curing when being irradiated with light. A state of the pressure-sensitive adhesive composition irradiated by the light is not particularly limited, but for example, when the pressure-sensitive adhesive composition is coated on a specific base and present in a semi-solid or solid type at a room temperature, light radiation may be performed.

In one embodiment, the pressure-sensitive adhesive composition may include a curable resin. As the curable resin, any one of resins cured by light may be used without particular limitation, and for example, a photocurable resin or a resin capable of being both photocured and heat-cured may be used.

In one embodiment, when the pressure-sensitive adhesive composition is applied to an organic electronic device sensitive to heat, among curable resins, a material generating less heat may be used while curing is performed by light.

As an example of such a curable resin, an acryl resin, an epoxy resin, an epoxidized polybutadiene, an epoxy (meth)acrylate, or a mixture thereof may be used.

Among these, as an example of the acryl resin, an acryl polymer prepared by polymerizing an alkyl (meth)acrylate and a polymerizable monomer having a crosslinkable functional group may be used. The "(meth)acrylate" used herein refers to an acrylate or a methacrylate.

The alkyl (meth)acrylate possibly uses a known material without limitation. For example, in consideration of physical properties such as a cohesive strength, a glass transition temperature, and pressure-sensitive adhesiveness, an alkyl (meth)acrylate having an alkyl group having 1 to 14 carbon atoms may be used. As an example of such an alkyl (meth)acrylate, methyl (meth)acrylate, ethyl (meth)acrylate, n-propyl (meth)acrylate, isopropyl (meth)acrylate, n-butyl (meth)acrylate, isobutyl (meth)acrylate, t-butyl (meth)acrylate, pentyl (meth)acrylate, hexyl (meth)acrylate, 2-ethylhexyl (meth)acrylate, n-octyl (meth)acrylate, isooctyl (meth)acrylate, isononyl (meth)acrylate, isobornyl (meth)acrylate, methylethyl (meth)acrylate, lauryl (meth)acrylate, or tetradecyl (meth)acrylate may be used. In addition, the alkyl (meth)acrylate may be a compound prepared by polymerizing one or at least two of the above-described compounds.

As the polymerizable monomer having a crosslinkable functional group, various monomers known in the field of preparing an acryl polymer may be used. For example, the polymerizable monomer having a crosslinkable functional group such as a hydroxyl group, a carboxyl group, a nitrogen-containing group, an epoxy group, or an isocyanate group may be used. The polymerizable monomer having such a crosslinkable functional group may be a polymerizable monomer having a hydroxyl group such as 2-hydroxyethyl (meth)acrylate, 2-hydroxypropyl (meth)acrylate, 3-hydroxypropyl (meth)acrylate, 4-hydroxybutyl (meth)acrylate, 6-hydroxyhexyl (meth)acrylate, 8-hydroxyoctyl (meth)acrylate, 2-hydroxyethyleneglycol (meth)acrylate, or 2-hydroxypropyleneglycol (meth)acrylate; a polymerizable monomer having a carboxyl group such as (meth)acryl acid, 2-(meth)acryloyloxy acetic acid, 3-(meth)acryloyloxy propylic acid, 4-(meth)acryloyloxy butyric acid, an acrylic acid dimer, itaconic acid, maleic acid, or maleic acid anhydride; or a polymerizable monomer having a nitrogen-containing group such as (meth)acrylamide, N-butoxy methyl (meth)acrylamide, N-methyl (meth)acrylamide, (meth)acrylonitrile, N-vinyl pyrrolidone, or N-vinylcaprolactam.

The epoxy resin may be an aliphatic epoxy resin, an alicyclic epoxy resin, a bisphenol-based epoxy resin, a novolac-type epoxy resin, a naphthalene-type epoxy resin, a trisphenolmethane-type epoxy resin, an epoxy resin containing fluorine or bromine, a glycidyl ester epoxy resin, or a glycidyl amine-type epoxy resin. Among these, the alicyclic epoxy resin may be 3,4-epoxycyclohexylmethyl-3,4-epoxycyclohexane carboxylate, 2-(3,4-epoxycyclohexyl-5,5-spiro-3,4-epoxy)cyclohexane-meta-dioxane, or bis-(3,4-epoxycyclohexylmethyl)adipate. The bisphenol-based epoxy resin may be a bisphenol A-type epoxy resin, a hydrogenated bisphenol A-type epoxy resin, a bisphenol F-type epoxy resin, a hydrogenated bisphenol F-type epoxy resin, or a bisphenol S-type epoxy resin. As the bisphenol-based epoxy resin, for example, a compound commercially available under the trade name of ST4100 produced by Kukdo Chemical Co., Ltd. may be used.

The epoxidized polybutadiene may be, for example, a compound including a structure of Formula 1 or 2 in a main chain.

[Formula 1]

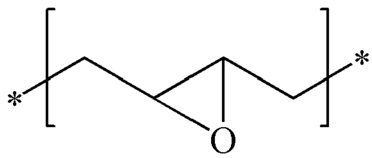

[Formula 2]

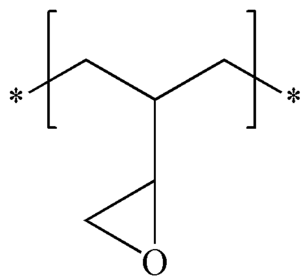

The epoxidized polybutadiene may be any material used in the art without limitation. For example, the epoxidized polybutadiene may be obtained by introducing an oxirane group to a double bond in a liquid polybutadiene resin by a reaction of the liquid polybutadiene resin with a peroxy acid such as a peracetic acid or a performic acid. Alternatively, the epoxidized polybutadiene may be obtained by a reaction of a liquid polybutadiene resin with an epoxy compound having a low molecular weight such as epihalohydrin.

The epoxidized polybutadiene may be, but is not limited to, compounds commercially available under the trade names of R-45EPI and R-15EPI produced by Idemitsu Petrochemical Co., Ltd.; compounds commercially available under the trade names of E-1000-8, E-1800-6.5, E-1000-3.5 and E-700-6.5 produced by Nippon Petrochemical Co., Ltd.; or a compound commercially available under the trade name of PB3600 produced by DAICEL.

The epoxy (meth)acrylate may be any material used in the art without limitation. For example, the epoxy (meth)acrylate is possibly manufactured by a reaction of an acryl resin with the above-described epoxy resin. For example, a compound prepared by a reaction of 2-carboxyethyl acrylate or 2-hydroxyethyl acrylate with glycerol diglycidyl ether, or diacrylate (commercially available under the trade name of EBERCRYL 600 produced by SK Cytec Co., Ltd.) of a

bisphenol A epoxy resin may be used as the epoxy (meth)acrylate.

In one embodiment, the curable resin may include at least two different kinds of resins or at least two same kinds of resins selected from an acryl resin, an epoxy resin, an epoxidized polybutadiene, and an epoxy (meth)acrylate. When at least two kinds of resins are used, contents thereof are not particularly limited, and may be suitably controlled according to a specific kind of the resin in consideration of a curing rate and a curing density. In one embodiment, as the at least two kinds of resins, epoxidized polybutadiene and an epoxy resin may be used together. Among these, content of the epoxidized polybutadiene may be, for example, 10 to 50 parts by weight, 10 to 45 parts by weight, 10 to 40 parts by weight, 10 to 37 parts by weight, 15 to 50 parts by weight, 17 to 50 parts by weight, 15 to 45 parts by weight, 17 to 40 parts by weight, or 17 to 37 parts by weight. In addition, content of the epoxy resin may be, for example, 50 to 90 parts by weight, 55 to 90 parts by weight, 60 to 90 parts by weight, 63 to 90 parts by weight, 50 to 85 parts by weight, 50 to 82 parts by weight, 55 to 85 parts by weight, 60 to 82 parts by weight, or 63 to 82 parts by weight.

In one embodiment, the pressure-sensitive adhesive composition may further include a photoinitiator. The photoinitiator may be any one used in the art without limitation. For example, as the photoinitiator, a radical initiator, a cationic initiator, or a mixture thereof may be used.

As the radical initiator, for example, benzoin, benzoinmethylether, benzoinethylether, acetophenone, 2,2-dimethoxy-2-phenylacetophenone, 2,2-diethoxy-2-phenylacetophenone, 2-methylanthraquinone, 2-ethylanthraquinone, or 2,4,6-trimethylbenzoyldiphenyl phosphine oxide (TPO) may be used.

The cationic initiator may be, for example, an aromatic diazonium salt, an aromatic iodine aluminum salt, an aromatic sulfonium salt, or an iron-arene complex. In addition, in one embodiment, as the cationic initiator, a product commercially available under the trade name of speedcure 976 produced by Lambson is possibly used.

Content of the photoinitiator may be, for example, 0.1 to 10 parts by weight, 0.1 to 8 parts by weight, 3 to 10 parts by weight, or 3 to 8 parts by weight relative to 100 parts by weight of the curable resin, but the present invention is not particularly limited thereto.

In one embodiment, the pressure-sensitive adhesive composition may further include a heat-curing agent. Since the heat-curing agent is included in the pressure-sensitive adhesive composition, for example, when the pressure-sensitive adhesive composition is irradiated with light and applied by heat, an adhesive having a more dense structure may be provided by the heat-curing agent. As the heat-curing agent, any one capable of heat-curing the above-described curable resin may be used without limitation. For example, the heat-curing agent may be an amine compound, an acid anhydride compound, an amide compound, a phenol compound, an imidazole compound, or a mixture thereof.

Such a heat-curing agent may be an amine compounds such as diaminodiphenylmethane, diethylenetriamine, triethylenetriamine, diaminodiphenylsulfone, or isophoronediamine; an acid anhydride compound such as phthalic anhydride, trimellitic anhydride, pyromellitic anhydride, maleic anhydride, tetrahydrophthalic anhydride, methyl tetrahydrophthalic anhydride, methylnadic anhydride, hexahydrophthalic anhydride, or methylhexahydrophthalic anhydride; an amide compound such as dicyandiamide or a polyamide synthesized from a dimer of linolenic acid and ethylenediamine; a phenol compound such as bisphenol A, bisphenol F, bisphenol S, fluorine bisphenol, or terpendiphenol; or an imidazole compound such as imidazole, 2-methylimidazole, 2-ethylimidazole, 2-ethyl-4-methylimidazole, 2-phenylimidazole, 4-phenylimidazole, 1-cyanoethyl-2-phenylimidazole, or 1-(2-cyanoethyl)-2-ethyl-4-methylimidazole.

In one embodiment, the pressure-sensitive adhesive composition may further include a moisture adsorbent such as a metal oxide, a metal salt, phosphorous pentoxide ($P_2O_5$), or a mixture thereof. The metal oxide may be, but is not limited to, lithium oxide, sodium oxide, barium oxide, calcium oxide, or magnesium oxide. The metal salt may be, but is not limited to, a sulfate such as lithium sulfate, sodium sulfate, calcium sulfate, magnesium sulfate, cobalt sulfate, gallium sulfate, titanium sulfate, or nickel sulfate; a metal halide such as calcium chloride, magnesium chloride, strontium chloride, yttrium chloride, copper chloride, cesium fluoride, tantalum fluoride, niobium fluoride, lithium bromide, calcium bromide, cesium bromide, selenium bromide, vanadium bromide, magnesium bromide, barium iodide, or magnesium iodide; or a metal chlorate such as barium perchlorate ($Ba(ClO_4)_2$) or magnesium perchlorate ($Mg(ClO_4)_2$).

In one embodiment, the pressure-sensitive adhesive composition may be used as an encapsulation layer composition for encapsulating an entire surface of the organic electronic element. Here, the organic electronic element refers to an element capable of inducing the flow of charges between an electrode and an organic material using a hole and/or electron. Such an organic electronic element may be an OLED, an organic solar cell, an organic photo conductor (OPC) drum, or an organic transistor.

In addition, the "encapsulating an entire surface of the organic electronic element" may mean that, for example, forming an encapsulation layer on an entire surface of one or both surfaces of the organic electronic element.

The substrate on which the organic electronic element is formed may be, for example, a substrate on which the above-described organic light emitting diode, organic solar cell, OPC drum, or organic transistor is formed.

In one embodiment, the organic electronic device may further include an encapsulation substrate in addition to the substrate on which the organic electronic element is formed. The encapsulation substrate may be located, for example, on the top surface of the substrate on which the organic electronic element is formed to encapsulate the organic electronic element. Such an encapsulation substrate may be attached to the substrate on which the organic electronic

element is formed by the encapsulation layer. Accordingly, the organic electronic element according to one embodiment is a structure whose top and bottom surfaces are encapsulated by the substrate and the encapsulation substrate and side and top surfaces are encapsulated by the encapsulation layer.

Materials for the substrate and encapsulation substrate may be a glass substrate or a plastic substrate without particular limitation. Generally, when a plastic substrate is used in an organic electronic device, since the plastic substrate has flexibility compared to the glass substrate, the phenomenon of bending the organic electronic device in the operation of curing the encapsulation layer frequently occurs. However, since the organic electronic device is encapsulated using the above-described pressure-sensitive adhesive film, even if a plastic substrate is used as the substrate and/or encapsulation substrate of the organic electronic device, the flexibility phenomenon may be minimized.

As the plastic substrate, any material used in the art is possibly used without limitation. For example, the material may be polyethylene terephthalate (PET), polyester, polyethylene naphthalate (PEN), polyetheretherketone (PEEK), polycarbonate (PC), polyethersulphone (PES), polyimide (PI), polyarylate (PAR), polycyclicolefin (PCO), or polynorbornene.

EFFECTS

According to the present invention, a method of manufacturing an organic electronic device including an encapsulation layer having excellent moisture barrier property and adhesiveness can be provided. In addition, according to the manufacturing method, for example, though the encapsulation layer is formed on an entire surface of an organic electronic element, a flexibility phenomenon of the organic electronic device can be minimized, and the organic electronic device can be manufactured without damage to the organic electronic element for a short process time.

BRIEF DESCRIPTION OF THE DRAWINGS

The above and other objects, features, and advantages of the present invention will become more apparent to those of ordinary skill in the art by describing in detail exemplary embodiments thereof with reference to the adhered drawings, in which:

FIG. 1 is a schematic diagram showing a process of manufacturing an organic electronic device according to an embodiment.

[Description of Reference Numerals]

10: substrate
20: encapsulation substrate
30: organic electronic element
40: pressure-sensitive adhesive film
50: encapsulation layer
60: direction of light radiation

DETAILED DESCRIPTION OF EXEMPLARY EMBODIMENTS

Hereinafter, a method of manufacturing an organic electronic device will be described in detail with reference to Examples and Comparative Examples, but a scope of the method of manufacturing an organic electronic device is not limited to the following Examples.

Hereinafter, physical properties in Examples and Comparative Examples are evaluated by the following methods.

**1. Evaluation of flexibility of organic light emitting device**

Pressure-sensitive adhesive films manufactured in Examples 1 to 2 and Comparative Examples 1 to 3 were laminated between a glass substrate having an area of 120 mm x 180 mm and a thickness of 0.5 T as a lower plate and a base film (100 μm) as an upper plate, and cured under curing conditions to be described in Examples 1 to 2 and Comparative Examples 1 to 3, thereby preparing samples. For example, the curing condition in Example 1 refers to a condition for primarily radiating UV rays at an intensity of approximately 5 $mW/cm^2$ for approximately 2 minutes, and secondarily performing post-curing at approximately 80 °C for 1 hour.

When one side of the sample prepared by applying the curing condition in each of Examples and Comparative Examples was fixed, a height of the other side apart from the ground was measured. Afterward, a degree of flexibility of the organic light emitting device was evaluated by examining how many times the height of the samples to which the curing condition of Examples 1 and 2 and Comparative Examples 1 and 3 were applied compared to that of the sample to which the curing condition of Comparative Example 2 was applied increased.

**2. Evaluation of damage to organic electronic device**

Damage to the organic light emitting device manufactured in Example or Comparative Example was evaluated by examining a change in brightness before and after the OLED was irradiated with UV rays. The changes in brightness before and after the UV radiation are shown in Table 1.

**3. Measurement of curing rate**

A curing rate of the pressure-sensitive adhesive film manufactured in Example or Comparative Example was calculated by measuring a heating value using a differential scanning calorimeter (DSC). A value calculated by measuring a remaining heating value (B) after the pressure-sensitive adhesive film was cured under the condition of Example or Comparative Example based on a heating value (A) obtained by heating the pressure-sensitive adhesive film at a rate of 10 °C/min from a room temperature to 300°C before curing was estimated as a curing rate.

$$\text{Curing rate (\%)} = (A - B) / A \times 100$$

**Example 1**

A pressure-sensitive adhesive composition having a solid content of 60 wt% was prepared by putting 5 parts by weight of a cationic initiator (speedcure 976, Lambson) based on 100 parts by weight of a curable resin into 35 parts by weight of epoxidized polybutadiene (PB3600, DAICEL) and 65 parts by weight of a hydrogenated bisphenol A-type epoxy resin (ST4100, Kukdo Chemical co., Ltd.) as the curable resins and adding the resulting product into methylcellosolve. Afterward, a pressure-sensitive adhesive film having a thickness of approximately 40 μm and exhibiting pressure-sensitive adhesive performance was manufactured using the pressure-sensitive adhesive composition as a coating solution.

The manufactured pressure-sensitive adhesive film was primarily laminated on glass for an encapsulation substrate, and irradiated with UV rays at an intensity of approximately 5 $mW/cm^2$ for approximately 2 minutes. Secondarily, by applying heat of approximately 70 °C and a pressure of approximately 2 kgf in a vacuum environment less than 100 mTorr to the pressure-sensitive adhesive film using a vacuum laminator, the other surface of the pressure-sensitive adhesive film laminated on the glass for the encapsulation substrate was laminated with a substrate on which an organic light emitting device was formed. Afterward, the resulting product was subjected to post-curing at approximately 80 °C for 1 hour, resulting in manufacturing an organic light emitting device.

**Example 2.**

A pressure-sensitive adhesive composition, a pressure-sensitive adhesive film, and an organic light emitting device were measured by the same method as described in Example 1, except that 20 parts by weight of epoxidized polybutadiene (PB3600, DAICEL) and 80 parts by weight of a hydrogenated bisphenol A-type epoxy resin (ST4100, Kukdo Chemical co., Ltd.) were used as the curable resins.

**Comparative Example 1.**

An organic light emitting device was manufactured by the same method as described in Example 1, except that the primarily laminated encapsulation substrate and pressure-sensitive adhesive film in Example 1 were irradiated with UV rays for approximately 30 seconds, and the secondarily-laminated substrate, pressure-sensitive adhesive film, and encapsulation substrate were subjected to post-curing at 100 °C for 1 hour.

**Comparative Example 2.**

An organic light emitting device was manufactured by the same method as described in Example 1, except

that the primarily laminated encapsulation substrate and pressure-sensitive adhesive film in Example 1 were irradiated with UV rays for approximately 30 minutes, and the secondarily-laminated substrate, pressure-sensitive adhesive film, and encapsulation substrate were not subjected to an additional curing process.

**Comparative Example 3.**

An organic light emitting device was manufactured by the same method as described in Example 1, except that the primarily laminated encapsulation substrate and pressure-sensitive adhesive film in Example 1 were irradiated with UV rays at an intensity of 200 mW/cm$^2$ for approximately 10 seconds.

The organic light emitting devices in Examples 1 and 2 and Comparative Examples 1 to 3 were evaluated with the above-described evaluation parameters, and the results are shown in Table 1.

[Table 1]

| | | Curing conditions | Curing rate | Flexibility evaluation | Change in brightness before and after UV radiation to examine damage of OLED |
|---|---|---|---|---|---|
| Example | 1 | UV 5 mW/cm$^2$ × 2 min<br>80 °C × 1 hr | 90% | 1.09 | 0.2% |
| | 2 | UV 5 mW/cm$^2$ × 2 min<br>80 °C × 1 hr | 92% | 1.91 | 0.1% |
| Comparative Example | 1 | UV 5 mW/cm$^2$ × 30 sec<br>100 °C × 1 hr | 93% | 3.36 | 0.5% |
| | 2 | UV 5 mW/cm$^2$ × 30 min | 55% | 1 | -0.5% |
| | 3 | UV 200 mW/cm$^2$ × 10 sec<br>80 °C × 1 hr | 95% | 2.27 | -3% |
| Flexibility evaluation unit: times<br>When the change in brightness before and after UV radiation is a positive number: brightness is increased<br>When the change in brightness before and after UV radiation is a negative number: brightness is decreased | | | | | |

## Claims

1. A method of manufacturing an organic electronic device, comprising:

   attaching a pressure-sensitive adhesive film (40) to a top surface of a substrate (10) on which an organic electronic element (30) is formed to encapsulate an entire surface of the organic electronic element (30);
   irradiating the pressure-sensitive adhesive film (40) encapsulating the entire surface of the organic electronic element (30) with light at an intensity of 0.1 to 100 mW/cm$^2$ for 10 seconds to 10 minutes so as to have a curing rate of 10% to 90%; and then applying heat to the pressure-sensitive adhesive film (40) at 70 to 90 °C for 30 minutes to 1 hour and 30 minutes,
   wherein the pressure-sensitive adhesive film (40) comprises a curable resin and a photoinitiator.

2. The method of claim 1, wherein the light has a wavelength of 300 to 450 nm.

3. The method of claim 1, wherein the curable resin is an acryl resin, an epoxy resin, an epoxidized polybutadiene, epoxy (meth)acrylate, or a mixture thereof.

4. The method of claim 1, wherein the photoinitiator is a radical initiator, a cationic initiator, or a mixture thereof.

5. The method of claim 1, wherein the pressure-sensitive adhesive film further comprises a heat-curing agent.

6. The method of claim 5, wherein the heat-curing agent is an amine compound, an acid anhydride compound, an amide compound, a phenol compound, an imidazole compound, or a mixture thereof.

7. The method of claim 1, wherein the pressure-sensitive adhesive film further comprises a moisture adsorbent such as a metal oxide, a metal salt, phosphorous pentoxide $P_2O_5$, or a mixture thereof.

8. The method of claim 1, further comprising attaching the pressure-sensitive adhesive film to an encapsulation substrate before the pressure-sensitive adhesive film is attached.

9. The method of claim 1, further comprising attaching the encapsulation substrate to one of the both surfaces of the pressure-sensitive adhesive film which is not attached to the organic electronic element after the attaching of the pressure-sensitive adhesive film.

10. The method of claim 1, wherein the attaching of the pressure-sensitive adhesive film is performed by roll lamination.

11. The method of claim 1, wherein the irradiating of the pressure-sensitive adhesive film with light is performed at 20 to 30 °C.

12. The method of claim 1, wherein, after the applying of heat to the pressure-sensitive adhesive film, the pressure-sensitive adhesive film does not comprise a photoinitiator.

## Patentansprüche

1. Verfahren zur Herstellung einer organischen, elektronischen Vorrichtung, umfassend:

   Anbringen eines drucksensitiven, adhäsiven Films (40) auf einer Oberseite eines Substrats (10), auf welchem ein organisches, elektronisches Element (30) gebildet wird, um eine gesamte Oberfläche des organischen, elektronischen Elements (30) zu ummanteln;
   Bestahlen des drucksensitiven, adhäsiven Films (40)
   Ummanteln der gesamten Oberfläche des organischen, elektronischen Elements (30) mit Licht einer Intensität von 0.1 bis 100 $mW/cm^2$ für 10 Sekunden bis 10 Minuten, um eine Aushärterate von 10% bis 90% zu haben; und dann Applizieren von Wärme auf den drucksensitiven, adhäsiven Film (40) bei 70 bis 90 °C, für 30 Minuten bis 1 Stunde und 30 Minuten,
   wobei der drucksensitive, adhäsive Film (40) ein härtbares Harz und einen Photoinitiator umfasst.

2. Verfahren nach Anspruch 1, wobei das Licht eine Wellenlänge von 300 bis 450 nm hat.

3. Verfahren nach Anspruch 1, wobei das härtbare Harz ein Acrylharz, ein Epoxidharz, ein epoxidiertes Polybutadien, Epoxy(meth)acrylat, oder eine Mischung davon ist.

4. Verfahren nach Anspruch 1, wobei der Photoinitiator ein radikalischer Initiator, ein kationischer Initiator, oder eine Mischung davon ist.

5. Verfahren nach Anspruch 1, wobei der drucksensitive, adhäsive Film weiterhin ein wärmehärtendes Mittel umfasst.

6. Verfahren nach Anspruch 5, wobei das wärmehärtende Mittel eine Aminverbindung, eine Säureanhydridverbindung, eine Amidverbindung, eine Phenolverbindung, eine Imidazolverbindung, oder eine Mischung davon ist.

7. Verfahren nach Anspruch 1, wobei der drucksensitive, adhäsive Film weiterhin ein Feuchtigkeitsabsorbens, wie zum Beispiel ein Metalloxid, ein Metallsalz, Phosphorpentoxid $P_2O_5$, oder eine Mischung davon, umfasst.

8. Verfahren nach Anspruch 1, weiterhin umfassend das Anbringen des drucksensitiven, adhäsiven Films auf ein ummanteltes Substrat, bevor der drucksensitive, adhäsive Film angebracht wird.

9. Verfahren nach Anspruch 1, weiterhin umfassend das Anbringen des ummantelten Substrats auf einer der beiden Oberflächen des drucksensitiven, adhäsiven Films, welches nicht, nach dem Anbringen des drucksensitiven, adhäsiven Films, auf dem organischen, elektronischen Element angebracht wird.

**10.** Verfahren nach Anspruch 1, wobei das Anbringen des drucksensitiven, adhäsiven Films durch Rolllaminierung ausgeführt wird.

**11.** Verfahren nach Anspruch 1, wobei das Bestahlen des drucksensitiven, adhäsiven Films mit Licht bei 20 bis 30 °C ausgeführt wird.

**12.** Verfahren nach Anspruch 1, wobei nach dem Applizieren von Wärme auf den drucksensitiven, adhäsiven Film, der drucksensitive, adhäsive Film keinen Photoinitiator umfasst.

**Revendications**

**1.** Procédé de fabrication d'un dispositif électronique organique, comprenant :

la fixation d'un film adhésif sensible à la pression (40) à une surface supérieure d'un substrat (10) sur lequel un élément électronique organique (30) est formé pour encapsuler une surface entière de l'élément (30) ;
l'irradiation du film adhésif sensible à la pression (40) encapsulant la surface entière de l'élément électronique organique (30) avec de la lumière à une intensité de 0,1 à 100 $mW/cm^2$ pendant 10 secondes à 10 minutes afin d'obtenir un taux de durcissement de 10 % à 90 % ; puis
l'application de chaleur sur le film adhésif sensible à la pression (40) à 70 à 90 °C pendant 30 minutes à 1 heure et 30 minutes,
dans lequel le film adhésif sensible à la pression (40) comprend une résine durcissable et un photo-initiateur.

**2.** Procédé selon la revendication 1, dans lequel la lumière possède une longueur d'onde de 300 à 450 nm.

**3.** Procédé selon la revendication 1, dans lequel la résine durcissable est une résine acrylique, une résine époxy, un polybutadiène époxidé, un (méth)acrylate d'époxy, ou un mélange de ceux-ci.

**4.** Procédé selon la revendication 1, dans lequel le photo-initiateur est un initiateur radical, un initiateur cationique, ou un mélange de ceux-ci.

**5.** Procédé selon la revendication 1, dans lequel le film adhésif sensible à la pression comprend en outre un agent durcissant à la chaleur.

**6.** Procédé selon la revendication 5, dans lequel l'agent durcissant à la chaleur est un composé amine, un composé anhydride acide, un composé amide, un composé phénol, un composé imidazole, ou un mélange de ceux-ci

**7.** Procédé selon la revendication 1, dans lequel le film adhésif sensible à la pression comprend en outre un adsorbant d'humidité tel qu'un oxyde de métal, un sel de métal, du pentoxyde phosphoreux $P_2O_5$, ou un mélange de ceux-ci.

**8.** Procédé selon la revendication 1, comprenant en outre la fixation du film adhésif sensible à la pression à un substrat d'encapsulation avant que le film adhésif sensible à la pression soit fixé.

**9.** Procédé selon la revendication 1, comprenant en outre la fixation du substrat d'encapsulation à l'une des deux surfaces du film adhésif sensible à la pression qui n'est pas fixée à l'élément électronique organique après la fixation du film adhésif sensible à la pression.

**10.** Procédé selon la revendication 1, dans lequel la fixation du film adhésif sensible à la pression est réalisée par stratification au rouleau.

**11.** Procédé selon la revendication 1, dans lequel l'irradiation du film adhésif sensible à la pression avec lumière est réalisée à 20 à 30 °C.

**12.** Procédé selon la revendication 1, dans lequel, après l'application de chaleur sur le film adhésif sensible à la pression, le film adhésif sensible à la pression ne comprend pas un photo-initiateur.

Fig. 1

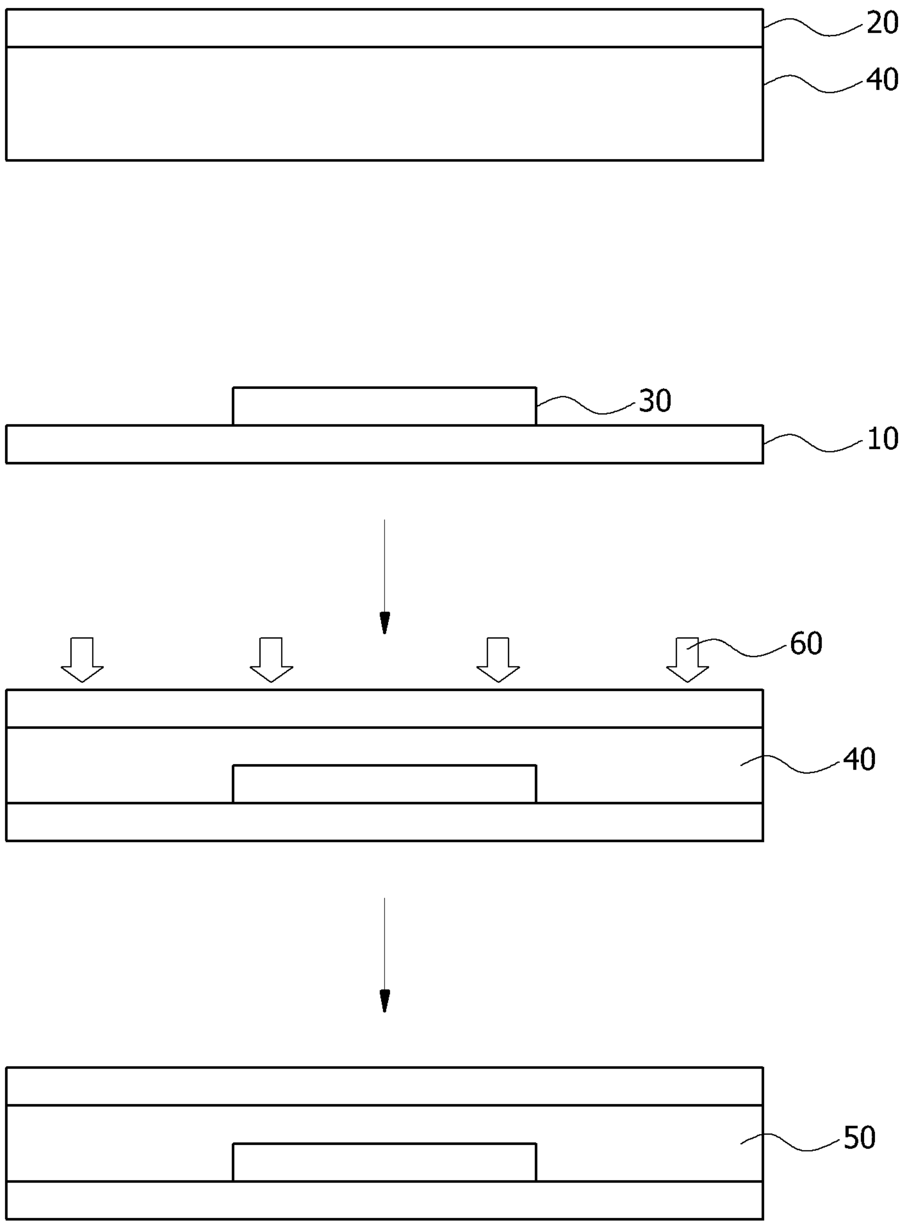

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008095545 A